(19) Europäisches Patentamt
European Patent Office
Office européen des brevets

(11) **EP 4 675 285 A1**

(12) **EUROPEAN PATENT APPLICATION**

(43) Date of publication:
**07.01.2026 Bulletin 2026/02**

(21) Application number: **24306075.3**

(22) Date of filing: **02.07.2024**

(51) International Patent Classification (IPC):
**G01R 19/25** (2006.01)    **G01R 31/3835** (2019.01)
**G01R 35/00** (2006.01)

(52) Cooperative Patent Classification (CPC):
**G01R 19/2503; G01R 31/3835; G01R 35/005**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **NXP USA, Inc.**
**Austin TX 78735 (US)**

(72) Inventors:
• **Cassagnes,, Thierry Dominique Yves**
**31023 Toulouse (FR)**

• **Tico,, Olivier**
**31023 Toulouse (FR)**
• **Lecce,, Sergio**
**5656 AG Eindhoven (NL)**
• **Bernon,, Valerie**
**31023 Toulouse (FR)**

(74) Representative: **Schmütz, Christian Klaus Johannes**
**NXP Semiconductors Germany GmbH**
**Intellectual Property Group**
**Beiersdorfstr. 12**
**22529 Hamburg (DE)**

(54) **A BATTERY MANAGEMENT SYSTEM**

(57) A battery management system comprising: a plurality of analog-to-digital converters, ADCs, each ADC comprising: a first switched capacitor circuit comprising first and second primary input terminals for connecting to respective primary measurement pins of a battery cell, wherein the first switched capacitor circuit is configured to sample a primary cell voltage across the first and second primary input terminals; a second switched capacitor circuit comprising first and second secondary input terminals for connecting to respective cell balancing pins of the battery cell wherein the second switched capacitor circuit is configured to sample a secondary cell voltage across the first and second secondary input terminals; a digital conversion circuit for providing a digital measurement of an input voltage; a diagnostic reference circuit configured to provide a diagnostic reference voltage for testing the function of the digital converter circuit; and a selection circuit configured to selectively connect the digital converter circuit to one or more of: the first switched capacitor circuit, the second switched capacitor circuit and the diagnostic reference circuit.

**Figure 2**

## Description

### Field

The present disclosure relates to a battery management system (BMS) and an analog-to-digital converter (ADC) for a BMS.

### Background

A Battery Management System (BMS) is an electronic control circuit that can monitor, measure and control the voltage level during charging and discharge of battery cells. Many systems include battery cells in a stack of cells (sometimes hundreds of cells) to provide a higher voltage. A BMS can track the performance and condition of each cell in the stack and measure the cell voltage to prevent over or under charging. A BMS may include an ADC to measure the voltage of each battery cell.

### Summary

According to a first aspect of the present disclosure there is provided a battery management system comprising: a plurality of analog-to-digital converters, ADCs, each ADC comprising:

> a first switched capacitor circuit comprising first and second primary input terminals for connecting to respective primary measurement pins of a battery cell, wherein the first switched capacitor circuit is configured to sample a primary cell voltage across the first and second primary input terminals;
> a second switched capacitor circuit comprising first and second secondary input terminals for connecting to respective cell balancing pins of the battery cell wherein the second switched capacitor circuit is configured to sample a secondary cell voltage across the first and second secondary input terminals;
> a digital conversion circuit for providing a digital measurement of an input voltage;
> a diagnostic reference circuit configured to provide a diagnostic reference voltage for testing the function of the digital converter circuit; and
> a selection circuit configured to selectively connect the digital converter circuit to one or more of: the first switched capacitor circuit, the second switched capacitor circuit and the diagnostic reference circuit.

In one or more embodiments, the first switched capacitor circuit may comprise first and second primary input capacitors for coupling the first switched capacitor circuit to the digital converter circuit. The first switched capacitor circuit may comprise a primary switching arrangement. The primary switching arrangement may be configured to arrange the first switched capacitor circuit in: (i) a first switching configuration in which the first primary input terminal is coupled to the first primary input capacitor and the second primary input terminal is coupled to the second primary input capacitor; and (ii) a second switching configuration in which the first primary input terminal is coupled to the second primary input capacitor and the second primary input terminal is coupled to the first primary input capacitor. The primary switching arrangement may be configured to switch the first and second primary input terminals to different ones of the first and second primary input capacitors.

In one or more embodiments, the second switched capacitor circuit may comprise first and second secondary input capacitor arrangements for coupling the second switched capacitor circuit to the digital converter circuit. The second switched capacitor circuit may comprise a secondary switching arrangement. The secondary switching arrangement may be configured to arrange the second switched capacitor circuit in: (i) a first switching configuration in which the first secondary input terminal is coupled to the first secondary input capacitor arrangement and the second secondary input terminal is coupled to the second secondary input capacitor arrangement; and (ii) a second switching configuration in which the first secondary input terminal is coupled to the second secondary input capacitor arrangement and the second secondary input terminal is coupled to the first secondary input capacitor arrangement. The secondary switching arrangement may be configured to switch the first and second secondary input terminals to different ones of the first and second secondary input capacitor arrangements.

In one or more embodiments, the first switched capacitor circuit and the second switched capacitor circuit may comprise high-voltage switched capacitor circuits for connecting to the battery cell. The first switched capacitor circuit and the second switched capacitor circuit may output a voltage that is less than the battery voltage. The digital converter circuit and the diagnostic reference circuit may comprise digital / CMOS voltage levels.

In one or more embodiments, the selection circuit may be configured to selectively configure the ADC in a diagnostic configuration in which the selection circuit connects the diagnostic reference circuit to the digital converter circuit, disconnects the first switched capacitor circuit from the digital converter circuit and disconnects the second switched capacitor circuit from the digital converter circuit.

In one or more embodiments, the digital converter circuit may comprise an integrator. The diagnostic reference voltage may correspond to a full-scale voltage range of the integrator.

In one or more embodiments, the diagnostic reference circuit may be configured to provide a plurality of different diagnostic reference voltages within the full-scale voltage range of the integrator.

In one or more embodiments, the plurality of different diagnostic reference voltages may include:

a first diagnostic reference voltage from -95% to -85% of the full-scale voltage of the integrator; and
a second diagnostic reference voltage from +85% to +95% of the full scale voltage of the integrator.

In one or more embodiments, the plurality of diagnostic reference voltages may include:

a third diagnostic reference voltage from -15% to -5% of the full-scale voltage of the integrator; and
a fourth diagnostic reference voltage from 5% to 15% of the full-scale voltage of the integrator.

In one or more embodiments, the selection circuit may be configured to selectively configure the ADC in a primary measurement configuration in which the selection circuit connects the first switched capacitor circuit to the digital converter circuit, disconnects the second switched capacitor circuit from the digital converter circuit and disconnects the diagnostic reference circuit from the digital converter circuit.

In one or more embodiments, the selection circuit may be configured to selectively configure the ADC in a secondary measurement configuration in which the selection circuit connects the second switched capacitor circuit to the digital converter circuit, disconnects the first switched capacitor circuit from the digital converter circuit and disconnects the diagnostic reference circuit from the digital converter circuit.

In one or more embodiments, the selection circuit may be configured to selectively configure the ADC in a safety configuration in which the selection circuit connects the first switched capacitor circuit to the digital converter circuit, connects the second switched capacitor circuit to the digital converter circuit and decouples the diagnostic reference circuit from the digital converter circuit.

In one or more embodiments, in the safety configuration, the first switched capacitor circuit may be configured to sample the primary cell voltage to provide a sampled primary cell voltage having a first polarity. The second switched capacitor circuit may be configured to sample the secondary cell voltage to provide a sampled secondary cell voltage having a second polarity opposite to the first polarity.

In one or more embodiments, the first switched capacitor circuit may comprise first and second primary input capacitors for coupling the sampled primary cell voltage to the digital converter circuit. The second switched capacitor circuit may comprise first and second secondary input capacitor arrangements for coupling the sampled secondary cell voltage to the converter circuit.

In one or more embodiments, a capacitance of each of the secondary input capacitor arrangements may be less than a capacitance of each of the primary input capacitors.

In one or more embodiments, a capacitance of each of the secondary input capacitor arrangements may be adjustable between a plurality of capacitance values. Each of the plurality of the capacitance values may be less than or equal to the capacitance of each of the primary input capacitors.

In one or more embodiments, the first switched capacitor circuit may comprise a primary switching arrangement and the second switched capacitor circuit may comprise a secondary switching arrangement. In the safety configuration, the primary switching arrangement and the secondary switching arrangement may be configured to selectively arrange the ADC in:

a first switching configuration in which:

the first primary input terminal is coupled to the first primary input capacitor;
the second primary input terminal is coupled to the second primary input capacitor;
the first secondary input terminal is coupled to the second secondary input capacitor arrangement; and
the second secondary input terminal is coupled to the first secondary input capacitor; and

a second switching configuration in which:

the first primary input terminal is coupled to the second primary input capacitor;
the second primary input terminal is coupled to the first primary input capacitor;
the first secondary input terminal is coupled to the first secondary input capacitor arrangement; and
the second secondary input terminal is coupled to the second secondary input capacitor arrangement.

According to a second aspect of the present disclosure there is provided an analog-to-digital converter, ADC, comprising:

a first switched capacitor circuit comprising first and second primary input terminals for connecting to respective primary measurement pins of a battery cell, wherein the first switched capacitor circuit is configured to sample a primary cell voltage across the first and second primary input terminals;
a second switched capacitor circuit comprising first and second secondary input terminals for connecting to respective cell balancing pins of the battery cell wherein the second switched capacitor circuit is configured to sample a secondary cell voltage across the first and second secondary input terminals;
a digital conversion circuit for providing a digital measurement of an input voltage;
a diagnostic reference circuit configured to provide a diagnostic reference voltage for testing the function of the digital converter circuit; and
a selection circuit configured to selectively connect the digital converter circuit to one or more of: the first switched capacitor circuit, the second switched capacitor circuit and the diagnostic reference circuit.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows an example of a redundant ADC arrangement; and
Figure 2 illustrates an example ADC according to an embodiment of the present disclosure.

## Detailed Description

The latest trend in the BMS market is to provide one ADC per measured battery cell voltage. Since the ASIL D (Automotive Safety Integrity Level D) standard at chip level calls for fully redundant measurements, an N-cell monitoring device can require 2 x N ADCs to comply with the ASIL D standard. This gets particularly expensive in relation to semiconductor die area as BMS chips increase the number of cells they can manage. For example, an 18-cell BMS would require 36 ADCs.

The present disclosure provides a new Analog Front-End for a BMS with dual inputs that allows sampling the battery cell voltages through separate input pins while still complying with the expectations of the ASILD standard. This dual-input Analog Front-End stage can save a significant amount of die area and power consumption for the overall product, providing an advantageous solution for BMS products, especially when larger numbers of cells are monitored in a single BMS Integrated Circuit.

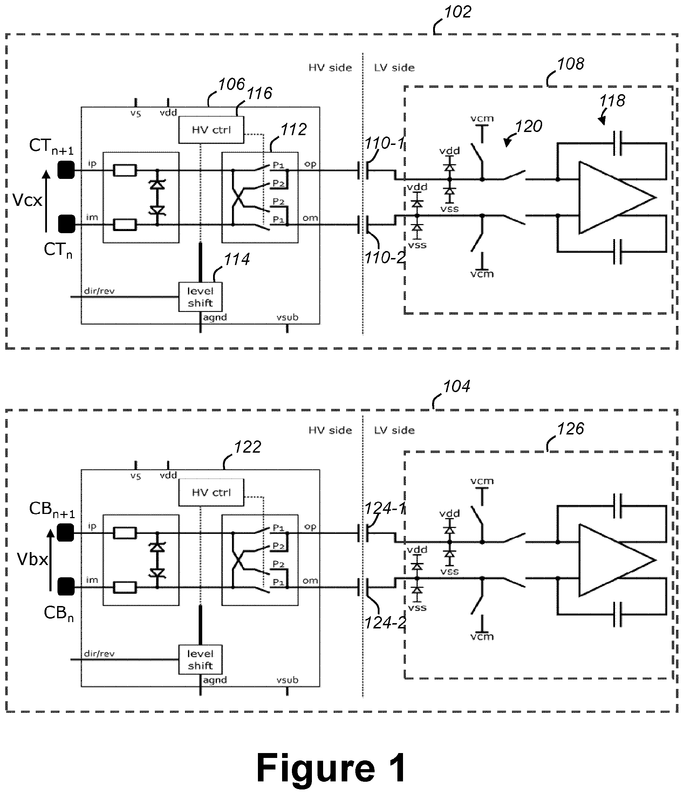

Figure 1 illustrates an example redundant ADC arrangement for redundant measurement of the cell voltage of a battery cell.

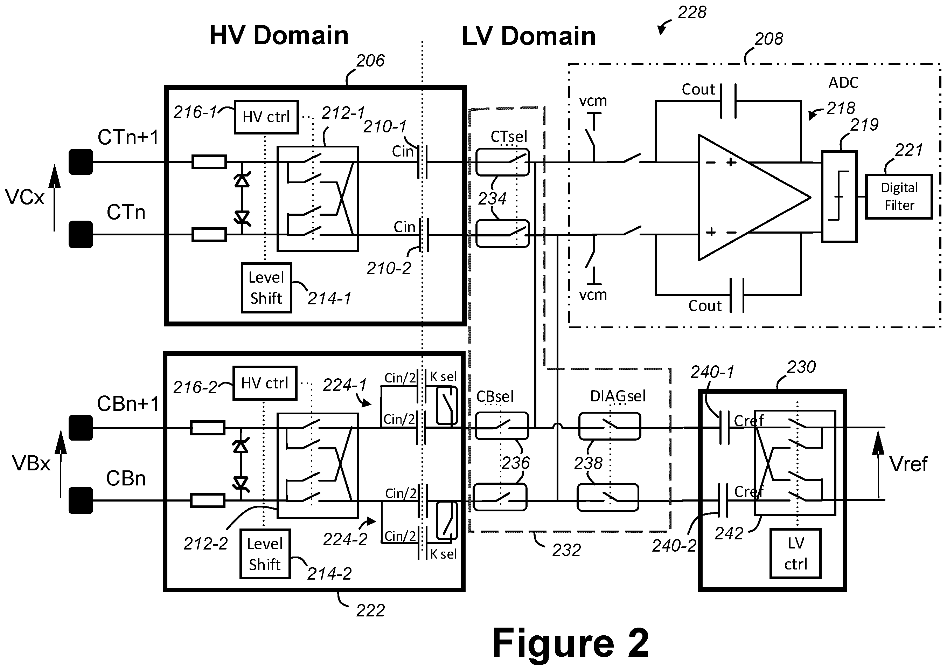

The ADC arrangement comprises a first ADC 102 and a second ADC 104. The first ADC and second ADC comprise a CMOS (complementary metal oxide semiconductor) ADC with switched capacitor inputs. Such ADC topologies are known and only briefly described here. The illustrated portions of the first ADC 102 and the second ADC 104 each form a switched capacitor integrator. Such switched capacitor integrators are known in the art and may each further comprise a comparator circuit and a digital filter circuit at the output (like in Figure 2) to form the respective ADC 102, 104.

The first ADC 102 comprises a first switched capacitor circuit 106 comprising first and second primary input terminals, $CT_n$, $CT_{n+1}$, configured to connect to a battery cell. The primary input terminals, $CT_n$, $CT_{n+1}$, may be connected to primary measurement pins of the battery cell. The first ADC 102 also comprises a first digital converter circuit 108. A pair of primary input capacitors 110-1, 110-2 couple the first switched capacitor circuit 106 to the digital converter circuit 108. In some examples, the first switched capacitor circuit 106 includes the pair of primary input capacitors 110-1, 110-2. The first switched capacitor circuit 106 (and the primary input capacitors 110-1, 110-2) comprise a high voltage (HV) domain or side of the ADC 102 and the digital converter circuit 108 comprises a low voltage domain of the ADC. The primary input capacitors 110-1, 110-2 may be HV capacitors that separate the HV domain from the LV domain. As described herein, the HV domain comprises HV components (HV capacitors to support high common mode voltage and medium voltage ~6V or 10V devices to support differential cell voltage) that can tolerate the differential voltage (cell voltage $Vcx$) across the primary input terminals, $CT_n$, $CT_{n+1}$, and the absolute voltage at each pin. In some examples, the differential voltage / cell voltage, $Vcx$, may be on the order of 6V while the absolute voltage may be anywhere from 0V to 200V, for example 90V or 100V, relative to ground. For example, a stack of 18 x 6V cells can provide a voltage of ~100V relative to a ground. As described herein, the LV domain may be configured to operate at CMOS voltage levels. In this example, the LV domain may relate to voltages up to 1.6 V.

The first switched capacitor circuit 106 comprises a switching circuit 112 configured to couple: (i) a first primary input terminal, $CTn$, to a first primary input capacitor 110-1 and a second primary input terminal, $CTn+1$, to a second primary input capacitor 110-2, in a first switching configuration (closing the pair of switches labelled P1 and opening the pair of switches labelled P2); and (ii) the first primary input terminal, $CTn$, to the second primary input capacitor 110-2 and the second primary input terminal CTn+1 to the first primary input capacitor 110-1, in a second switching configuration (closing the pair of switches labelled P2 and opening the pair of switches labelled P1). In this way, the first switched capacitor circuit 106 can provide HV sampling of the primary cell voltage VCx across the primary pins of the battery cell. The first and second primary input capacitors 110-1, 110-2 can couple the sampled primary cell voltage to the digital converter circuit 108.

A level shift circuit 114 and an HV control circuit 116 provide control signals to the control terminals (e.g. transistor gates) of switches of the switching circuit 112. The level shift circuit 114 is configured to provide control signals that have a cell common mode voltage offset relative to the input voltage at one of the primary input terminals, $CT_n$, $CT_{n+1}$, because the input voltage will vary as the cell is charged and discharged (in this example, the level shifter is using capacitive coupling techniques, therefore only two High voltage capacitances are transmitting differential control signals to medium voltage ~6V devices located in the HV control circuit 116). By providing control signals that track the input voltage at the primary input terminals, $CT_n$, $CT_{n+1}$, a consistent gate-source voltage can be maintained at the switches of the switching circuit 112 thereby providing an accurate sampled primary cell voltage to the primary input capacitors 110-1, 110-2.

In this example, the digital converter circuit 108 comprises a delta-sigma modulator. For simplicity, the figure only illustrates an integrator 118 and a sampling switch arrangement 120. The delta-sigma modulator can comprise any known delta-sigma topology including a feedback path and modulator reference voltage and is not described in detail here. The sampling switch arrangement 120 is configured to: (i) during a first phase, couple the first primary input capacitor to a first input of the integrator 118 and couple the second primary input capacitor 110-2 to a second input of the integrator; and (ii) during a second phase, decouple the first and second primary input capacitors 110-1, 110-2 from the integrator 118 and couple a common mode voltage to the inputs of the integrator 118. In this way, the digital converter circuit 108 can accurately sample and measure the sampled primary cell voltage. The digital convertor circuit 108 may also include a comparator circuit (not shown) and a digital filter circuit (not shown) downstream of the integrator 118 to provide an accurate digital measurement signal corresponding to the analog cell voltage $Vcx$. The comparator circuit and digital filter circuit are also in the LV domain.

The second ADC 104 is substantially identical to the first ADC 102. The second ADC comprises a second switched capacitor circuit 122 with first and second cell balancing (or secondary) input terminals, $CBn$, $CBn+1$, configured to couple to the cell balancing pins of the battery cell. The second switched capacitor circuit 122 otherwise operates in the same way as the first switched capacitor circuit 106. The second ADC 104 also comprises a pair of secondary input capacitors 124-1, 124-2 and a second digital converter circuit 126 that operate in the same way as the pair of primary input capacitors 110-1, 110-2 and the first digital converter circuit 108 of the first ADC 102.

In summary, the ADC arrangement includes a first ADC 102 to measure the primary cell voltage, $VCx$, at the primary measurement pins of a battery cell and an identical second ADC 104 to measure the secondary cell voltage, $VBx$, at the cell balancing pins of the battery cell. In normal operation, the primary cell voltage across the primary measurement pins and the secondary cell voltage across the cell balancing pins should be equal. In this way, the ADC arrangement provides fully redundant cell voltage measurement capability for a BMS to meet the ASIL-D standard. However, as noted above, providing duplicate ADCs 102, 104 for each cell requires a large die area on a BMS integrated circuit, particularly for BMS ICs that monitor a large number of battery cells.

Figure 2 illustrates a dual input ADC 228 (or ADC arrangement) for a battery management system according to an embodiment of the present disclosure. Features of Figure 2 that are also present in Figure 1 have corresponding reference numbers in the 200 series and will not necessarily be described again here.

The ADC 228 of Figure 2 includes similar features to the two ADC arrangement of Figure 1. The ADC 228 includes first and second switched capacitor circuits 206, 222, and a (single) digital converter circuit 208. However, the first and second switched capacitor circuits, 206, 222, share the digital converter circuit 208. In other words, the second digital converter circuit of Figure 1 has been dispensed with. To avoid the digital converter circuit 208 acting as a single point of failure in the ADC 228, the ADC 228 includes a diagnostic reference circuit 230. The diagnostic reference circuit 230 is configured to provide a diagnostic reference voltage to the digital converter circuit 208 during a diagnostic mode to verify that the digital converter circuit 208 is functioning correctly. The ADC 228 also includes a selection circuit 232 configured to selectively connect the digital converter circuit 208 to one or more of: the first switched capacitor circuit 206, the second switched capacitor circuit 222 and the diagnostic reference circuit 230.

The digital converter circuit 208 accounts for approximately 90% of the input current, and approximately 50% of the die area, for a single ADC (such as each of the two ADCs of Figure 1). Therefore, by dispensing with the second digital converter circuit, the ADC 228 of Figure 2 advantageously results in an approximately 25% reduction in die area, and approximately 50% reduction in current consumption, relative to the redundant ADC arrangement of Figure 1.

The digital converter circuit 208 is configured to receive an input voltage, such as a sampled primary cell voltage from the first switched capacitor circuit 206, a sampled secondary cell voltage from the second switched capacitor circuit 222 or a diagnostic reference voltage from the diagnostic reference circuit 230. In this example, the digital converter circuit 208 comprises a delta sigma modulator. For simplicity, the figure only includes an integrator 218, sampling switch circuitry a comparator circuit 219 and a digital filtering circuit 221. The delta-sigma modulator can comprise any known delta-sigma topology including a feedback loop and modulator reference voltage (different to and fully independent of the diagnostic reference voltage, Vref). The combination of each switched capacitor circuit and the integrator may be referred to a switched capacitor integrator. The comparator circuit 219 and the digital filtering circuit are coupled downstream of the (switched capacitor) integrator 218 to provide an accurate digital representation of the input voltage. In other examples, the digital converter circuit 208 may comprise a sample and hold circuit for use as a buffer to an ADC. Digital converter circuits 208 (such as sigma-delta modulators or sample and hold circuits) and their functionality are known and not described in further detail here.

The first switched capacitor circuit 206 and the second switched capacitor circuit 222 both comprise the same features and operate in the same way as the first and second switched capacitor circuits described above in relation to Figure 1. In the same way as the example of Figure 1, the first switched capacitor circuit 206 comprises first and second primary input terminals, $CTn$, $CTn+1$, configured to couple to the primary measurement pins of the battery cell. The first switched capacitor circuit 206 is configured to sample the primary cell voltage, $VCx$, cross the primary input terminals, $CT_n$, $CT_{n+1}$. The second switched capacitor circuit 222 comprises first and second cell balancing input terminals, $CB_n$, $CB_{n+1}$, configured to couple to the cell balancing pins of the battery cell. The second switched capacitor circuit 222 is configured to sample the secondary cell voltage, $VBx$, cross the secondary input terminals, $CB_n$, $CB_{n+1}$.

In this example, the first switched capacitor circuit 206 includes first and second primary input capacitors 210-1, 210-2. The first and second primary input capacitors 210-1, 210-2 can couple the sampled primary cell voltage to the digital converter circuit 208. The second switched capacitor circuit 222 includes first and second secondary input capacitor arrangements 224-1, 224-2, which are described in more detail below. The first and second secondary input capacitor arrangements 224-1, 224-2 can couple the sampled secondary cell voltage to the digital converter circuit 208. The first and second primary input capacitors 210-1, 210-2 may be substantially identical and have the same capacitance. The first and second secondary input capacitor arrangements 224-1, 224-2 may be substantially identical and have the same capacitance.

The first switched capacitor circuit 206 includes a primary switching circuit 212-1, a primary level shift circuit 214-1 and a primary HV control circuit 216-1 that switch each primary input terminal, $CTn$, $CTn+1$, to a different one of the first and second primary input capacitors 210-1, 210-2, in the same way as described above for the first switched capacitor circuit of Figure 1. Similarly, the second switched capacitor circuit 222 includes a secondary switching circuit 212-2, a secondary level shift circuit 214-2, and a secondary HV control circuit 216-2 that switch each cell balancing input terminal, $CBn$, $CBn+1$, to a different one of the first and second secondary capacitor arrangements 224-1, 224-2, in the same way as described above for the first switched capacitor circuit of Figure 1. In this way, the first and second switched capacitor circuits 206, 222 can sample a respective primary/secondary cell voltage across the respective first and second primary/secondary input terminals. The first and second primary capacitors 210-1, 210-2, and first and second secondary capacitor arrangements 224-1, 224-2, can couple the respective sampled primary/secondary cell voltage, VCx, VBx, to the digital converter circuit 208.

The selection circuit 232 comprises three sets of switches: (i) primary selection switches 234 that are configured to selectively connect the first switched capacitor circuit 206 to the digital converter circuit 208 in response to a primary control signal, $CTsel$; (ii) secondary selection switches 236 that are configured to selectively connect the second switched capacitor circuit 222 to the digital converter circuit 208 in response to a secondary control signal, $CBsel$; and (iii) diagnostic selection switches 238 that are configured to selectively connect the diagnostic reference circuit 230 to the digital converter circuit 208 in response to a diagnostic control signal, $DIAGsel$.

In this example, the selection circuit 232 can configure the ADC 228 in four operation modes (or configurations).

1. Primary Measurement Mode

In a primary measurement mode, the primary control signal, $CTsel$, is set to close the primary selection switches 234. Both the secondary control signal, *CBsel,* and the diagnostic control signal, DIAGsel, are set to open the secondary selection switches 236 and the diagnostic selection switches 238. In this way, the selection circuit 232 connects the first switched capacitor circuit 206 to the digital converter circuit 208, disconnects the second switched capacitor circuit 222 from the digital converter circuit 208, and disconnects the diagnostic reference circuit 230 from the digital converter circuit 208. In the primary measurement mode, the first switched capacitor circuit 206 is connected to the digital converter circuit 208 and the ADC 228 measures the primary cell voltage VCx on the primary measurement pins of the battery cell. The first switched capacitor circuit 206 samples the primary cell voltage, VCx, and the primary input capacitors 210-1 210-2 couple the sampled primary cell voltage to the digital converter circuit 208 for digital measurement. The second switched capacitor circuit 222 and the diagnostic reference circuit 230 are disconnected from the digital converter circuit 208.

2. Secondary Measurement Mode

In a secondary measurement mode, the secondary control signal, *CBsel,* is set to close the secondary selection switches 236. Both the primary control signal, *CTsel,* and the diagnostic control signal, *DIAGsel,* are set to open the primary selection switches 234 and the diagnostic selection switches 238. In this way, the selection circuit 232 connects the second switched capacitor circuit 222 to the digital converter circuit 208, disconnects the first switched capacitor circuit 206 from the digital converter circuit 208, and disconnects the diagnostic reference circuit 230 from the digital converter circuit 208. In the secondary measurement mode, the second switched capacitor circuit 222 is connected to the digital converter circuit 208 and the ADC 228 measures the cell voltage VBx on the cell balancing pins of the battery cell. The second switched capacitor circuit 222 samples the secondary cell voltage, VBx, and the secondary input capacitor arrangements 224-1 224-2 couple the sampled secondary cell voltage to the digital converter circuit 208 for digital measurement. The first switched capacitor circuit 206 and the diagnostic reference circuit 230 are disconnected from the digital converter circuit 208.

The primary measurement mode can provide a more accurate measurement of the cell voltage than the secondary measurement mode. This is because the cell balancing pins of the battery cell are designed to handle high current in a cell balancing operation and therefore do not typically include a filtering circuit, unlike the primary measurement pins. Therefore, in some examples, the primary measurement mode may comprise a default operational mode of the ADC 228 and the secondary measurement mode may comprise a redundancy check. The primary measurement mode may be used for state of health measurements, electro-impedance spectroscopy and other BMS functions.

3. Safety Mode

The selection circuit 232 can arrange the ADC in a safety mode, where both the first and second switched capacitor circuits 206, 222 are connected to the digital converter circuit 208 at the same time. In this way, the safety mode can compare the sampled primary cell voltage to the sampled secondary cell voltage to check that the HV domain of the ADC 228 (i.e. the first and second switched capacitor circuits 206, 222) is functioning correctly.

In the safety mode, the primary control signal, *CTsel,* is set to close the primary selection switches 234 and the secondary control signal, *CBsel,* is set to close the secondary selection switches 236. The diagnostic control signal, *DIAGsel,* is set to open the diagnostic selection switches 238. In this way, the selection circuit 232 connects both the first switched capacitor circuit 206 and the second switched capacitor circuit 222 to the digital converter circuit 208, and disconnects the diagnostic reference circuit 230 from the digital converter circuit 208. In the safety mode, the first and second switched capacitor circuits 206, 222 are connected to the digital converter circuit 208 and the ADC 228 can compare the cell voltage VCx on the primary measurement pins to the cell voltage VBx on the cell balancing pins of the battery cell (by comparing the sampled primary cell voltage to the sampled secondary cell voltage). The diagnostic reference circuit 230 is disconnected from the digital converter circuit 208.

In the safety mode, the primary level shift circuit 214-1 and the primary HV control circuit 216-1 may control the primary switching circuit 212-1, and the secondary level shift circuit 214-2 and the secondary HV control circuit 216-2 may control the secondary switching circuit 212-2, to provide the sampled secondary cell voltage with an opposite polarity to the sampled primary cell voltage. In this way, the digital converter circuit 208 will receive the summed voltage, $V_T$:

$$V_T = VCx - VBx$$

If the first switched capacitor circuit 206 and the second switched capacitor circuit 222 are functioning correctly, the summed voltage, $V_T$, will be zero, or substantially zero (assuming that the secondary input capacitor arrangements 224-1, 224-2 have a capacitance equal to that of the primary input capacitors 210-1, 210-2).

It can be easier for the digital converter circuit 208 to measure a non-zero voltage than a zero-voltage level. Therefore, in some examples, the secondary input capacitor arrangements 224-1, 224-2 may have a capacitance that differs to the capacitance of the primary input capacitors 210-1, 210-2. In some examples, each of the secondary input capacitor arrangements 224-1, 224-2 may have a capacitance that is less than the capacitance of each of the primary input capacitors 210-1, 210-2. The capacitance of each of the secondary input capacitor arrangements 224-1, 224-2 may have a capacitance that is equal to k times the capacitance of each of the primary input capacitors 210-1, 210-2, wherein k is less than or equal to 1 and greater than zero. In this way, the summed voltage received at the digital converter circuit 208 will be:

$$V_T = VCx - k \cdot VBx$$

The summed voltage, $V_T$, will be a non-zero value ((1-k) times the cell voltage) if the first and second switched capacitor circuits 206, 222 are operating correctly. As the measurement is a safety check, it can be more robust for the digital converter circuit 208 to measure a non-zero (valid) result than a zero value.

In some examples, k may be programmable. In other words, the secondary input capacitor arrangements 224-1, 224-2 may each have an adjustable capacitance. In this way, the ADC 228 can perform multiple checks in the safety mode to confirm that the first and second switched capacitor circuits 206, 222 are operating correctly. In the example of Figure 2, k is adjustable between two values: 0.5 and 1.0. Each primary input capacitor 210-1, 210-2 has a capacitance of Cin. Each secondary input capacitor arrangement 224-1, 224-2 has a fixed capacitor with a capacitance of Cin/2 and a selectable capacitor with a capacitance of Cin/2 arranged in parallel to the fixed capacitor.

A capacitor selection switch, K-sel, controls whether the selectable capacitor is connected to the fixed capacitor. In this way, the secondary input capacitor arrangements 224-1, 224-2 have a capacitance that can be either Cin/2 or Cin, corresponding to k-values of 0.5 and 1.0. The digital converter circuit 208 can measure a voltage of VCx/2 when k=0.5 to confirm that the first and second switched capacitor circuits 206, 222 are operating correctly. Similarly, the digital converter circuit 208 can measure a voltage of zero when k=1.0 to confirm the first and second switched capacitor circuits 206, 222 are operating correctly. The illustrated example of capacitance values of Cin/2 and Cin is just one example and any values of capacitance may be used. In some examples, the secondary input capacitor arrangements may provide for more than two different k values.

The safety mode advantageously enables sampling both the primary cell voltage, VCx, at the primary measurement pins, and the secondary cell voltage, VBx, at the cell balancing pins at the same time which can reduce inaccuracies due to noise spikes or other transient effects because the summation (effectively a subtraction due to different sampling polarities) of the two cell voltages can cancel such transient voltage signals.

4. Diagnostic Mode

The first and second switched capacitor circuits 206, 222 provide redundancy for the HV domain of the ADC 228. As there is no second digital converter circuit, redundancy of the LV domain of the ADC 228 is achieved in a different manner, using the diagnostic reference circuit 230.

In the diagnostic mode, the diagnostic reference circuit 230 is connected to the digital converter circuit 208. The diagnostic reference circuit 230 can couple a diagnostic reference voltage to the digital converter circuit 208 that can test whether the digital converter circuit 208 is functioning correctly. The diagnostic reference voltage may test the full swing or range of the integrator 218 of the digital converter circuit 208.

In the diagnostic mode, the diagnostic control signal, *DIAGsel,* is set to close the diagnostic selection switches 238. Both the primary control signal, *CTsel,* and the secondary control signal, *CBsel,* are set to open the primary selection switches 234 and the secondary selection switches 236. In this way, the selection circuit 232 connects the diagnostic reference circuit 230 to the digital converter circuit 208, disconnects the first switched capacitor circuit 206 from the digital converter circuit 208, and disconnects the second switched capacitor circuit 222 from the digital converter circuit 208. In the diagnostic mode, the diagnostic reference circuit 230 is connected to the digital converter circuit 208 and the ADC 228 measures one or more diagnostic reference voltages to perform a diagnostic check on the digital converter circuit 208. The first switched capacitor circuit 206 and the second switched capacitor circuit 222 are disconnected from the digital converter circuit 208.

The diagnostic reference circuit 230 comprises a similar structure to the first and second capacitor circuits 206, 222 although the diagnostic reference circuit can advantageously be provided in the LV domain with corresponding LV components that take up a negligible die area and consume negligible current. The diagnostic reference circuit 230 receives a nominal diagnostic reference voltage, *Vref,* across first and second reference terminals.

The diagnostic reference circuit comprises first and second reference capacitors 240-1, 240-2. The diagnostic reference circuit 230 comprises a reference switching arrangement 242. The reference switching circuit receives a control signal from a LV control circuit. The reference switching circuit can configure the diagnostic reference circuit in: (i) a first reference switching configuration in which the first reference input terminal is coupled to the first reference capacitor 240-1 and the second reference input terminal is coupled to the second reference capacitor 240-2; and (ii) a second reference switching configuration in which the first reference input terminal is coupled to the second reference capacitor 240-2 and the second reference input terminal is coupled to the first reference capacitor 240-1. In this way, the diagnostic reference circuit 230 can sample the nominal diagnostic reference voltage at different sampling rates to provide a plurality of difference sampled diagnostic reference voltages. The first and second reference capacitors, 240-1, 240-2 can couple the sampled diagnostic reference voltage to the digital converter circuit.

The LV control circuit can control the reference switching arrangement 242 to sample the nominal reference voltage, *Vref,* at different sampling rates to provide a plurality of different sampled diagnostic reference voltages in a range from negative nominal diagnostic reference voltage to the diagnostic reference voltage [*-Vref...Vref*]. In some examples, the range of diagnostic reference voltages may be less than the full-scale voltage range of the integrator 218 of the digital converter circuit 208. For example, the range of diagnostic reference voltages may be from -90% of a full scale of the integrator 218 of the digital converter circuit to 90% of the full scale of the integrator 218. In some examples, the diagnostic reference voltages may further include lower voltage values such as $\pm$10% of the full scale.

In this way, the diagnostic reference circuit 230 emulates the operation of the first and second switched capacitor circuits 206, 222 by providing a series of known sampled diagnostic reference voltages to the digital converter circuit 208. The digital converter circuit 208 can be deemed to be functioning correctly if the resulting digitally measured voltages correspond to the known sampled diagnostic reference voltages.

In some examples, the nominal diagnostic reference voltage, Vref, may be programmable to provide the different diagnostic reference voltages to the digital converter circuit 208. For example, the nominal diagnostic reference voltage may be programmable to switch between a first diagnostic reference voltage of 10% full-scale for example and a second diagnostic reference voltage of 90% full-scale. The reference switching circuit 242 may then sample the two values of the nominal diagnostic reference voltage, Vref, to provide positive and negative values of each nominal diagnostic reference voltage, Vref.

A summary of the four modes/configurations of the ADC 228 is provided in table 1.

Table 1: Summary of four operation modes of ADC of Figure 2.

| Operation Mode | CTset | CBsel | DIAGsel | Comment |
|---|---|---|---|---|
| Primary Measurement | 1 | 0 | 0 | Measure Cell voltages on CTx pins |
| Secondary Measurement | 0 | 1 | 0 | Measure Cell voltages on CBx pins |
| Diagnostic mode | 0 | 0 | 1 | Internal diag mode : exercise Modulator Range |
| Safety Operation | 1 | 1 | 0 | VCx-VBx, VCx-k*VBx |

The disclosed ADC 228 advantageously provides the full redundancy required by the ASIL-D standard while reducing the required die area and current consumption relative to employing two ADCs per cell.

As described above, redundancy of the HV domain is provided by the first and second switched capacitor circuits 206, 222 and the functionality of the switched capacitor circuits 206, 222 can be checked by performing math operations on the primary and secondary cell voltages, *VCx, VBx,* in a safety mode.

The diagnostic reference circuit 230 advantageously provides redundancy for the LV domain and allows deployment of a near full-scale diagnostic reference voltage inside the modulator (digital converter circuit 208).

The disclosed ADC can include redundant digital registers to provide for parallel polling of the results from the digital converter circuit 208. However, the additional die area and current consumption required for the additional redundant registers is negligible relative to the die area and current consumption saved by removing the second digital converter circuit.

Redundant digital control signals may also be provided for each of the different switching arrangements to meet the ASIL-D standard.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated

EP 4 675 285 A1

therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A battery management system comprising:
   a plurality of analog-to-digital converters, ADCs, each ADC comprising:

   a first switched capacitor circuit comprising first and second primary input terminals for connecting to respective primary measurement pins of a battery cell, wherein the first switched capacitor circuit is configured to sample a primary cell voltage across the first and second primary input terminals;
   a second switched capacitor circuit comprising first and second secondary input terminals for connecting to respective cell balancing pins of the battery cell wherein the second switched capacitor circuit is configured to sample a secondary cell voltage across the first and second secondary input terminals;
   a digital conversion circuit for providing a digital measurement of an input voltage;
   a diagnostic reference circuit configured to provide a diagnostic reference voltage for testing the function of the digital converter circuit; and
   a selection circuit configured to selectively connect the digital converter circuit to one or more of: the first switched capacitor circuit, the second switched capacitor circuit and the diagnostic reference circuit.

2. The battery management system of claim 1, wherein the selection circuit is configured to selectively configure the ADC in a diagnostic configuration in which the selection circuit connects the diagnostic reference circuit to the digital converter circuit, disconnects the first switched capacitor circuit from the digital converter circuit and disconnects the second switched capacitor circuit from the digital converter circuit.

3. The battery management system of claim 1 or claim 2, wherein the digital converter circuit comprises an integrator and the diagnostic reference voltage corresponds to a full-scale voltage range of the integrator.

4. The battery management system of claim 3, wherein the diagnostic reference circuit is configured to provide a plurality of different diagnostic reference voltages within the full-scale voltage range of the integrator.

5. The battery management system of claim 4, wherein the plurality of different diagnostic reference voltages include:

   a first diagnostic reference voltage from -95% to -85% of the full-scale voltage of the integrator; and
   a second diagnostic reference voltage from +85% to +95% of the full scale voltage of the integrator.

6. The battery management system of claim 4 or claim 5, wherein the plurality of diagnostic reference voltages include:

   a third diagnostic reference voltage from -15% to -5% of the full-scale voltage of the integrator; and

a fourth diagnostic reference voltage from 5% to 15% of the full-scale voltage of the integrator.

7. The battery management system of any preceding claim, wherein the selection circuit is configured to selectively configure the ADC in a primary measurement configuration in which the selection circuit connects the first switched capacitor circuit to the digital converter circuit, disconnects the second switched capacitor circuit from the digital converter circuit and disconnects the diagnostic reference circuit from the digital converter circuit.

8. The battery management system of any preceding claim, wherein the selection circuit is configured to selectively configure the ADC in a secondary measurement configuration in which the selection circuit connects the second switched capacitor circuit to the digital converter circuit, disconnects the first switched capacitor circuit from the digital converter circuit and disconnects the diagnostic reference circuit from the digital converter circuit.

9. The battery management system of any preceding claim, wherein the selection circuit is configured to selectively configure the ADC in a safety configuration in which the selection circuit connects the first switched capacitor circuit to the digital converter circuit, connects the second switched capacitor circuit to the digital converter circuit and decouples the diagnostic reference circuit from the digital converter circuit.

10. The battery management system of claim 9, wherein, in the safety configuration, the first switched capacitor circuit is configured to sample the primary cell voltage to provide a sampled primary cell voltage having a first polarity and the second switched capacitor circuit is configured to sample the secondary cell voltage to provide a sampled secondary cell voltage having a second polarity opposite to the first polarity.

11. The battery management system of claim 9 or claim 10, wherein

the first switched capacitor circuit comprises first and second primary input capacitors for coupling the sampled primary cell voltage to the digital converter circuit; and
the second switched capacitor circuit comprises first and second secondary input capacitor arrangements for coupling the sampled secondary cell voltage to the converter circuit.

12. The battery management system of claim 11, wherein:
a capacitance of each of the secondary input capacitor arrangements is less than a capacitance of each of the primary input capacitors.

13. The battery management system of claim 11, wherein:
a capacitance of each of the secondary input capacitor arrangements is adjustable between a plurality of capacitance values, wherein each of the plurality of capacitance values is less than or equal to the capacitance of each of the primary input capacitors.

14. The battery management system of any of claims 11 to 13, wherein:

the first switched capacitor circuit comprises a primary switching arrangement and the second switched capacitor circuit comprises a secondary switching arrangement, and
in the safety configuration, the primary switching arrangement and the secondary switching arrangement are configured to selectively arrange the ADC in:

a first switching configuration in which:

the first primary input terminal is coupled to the first primary input capacitor;
the second primary input terminal is coupled to the second primary input capacitor;
the first secondary input terminal is coupled to the second secondary input capacitor arrangement; and
the second secondary input terminal is coupled to the first secondary input capacitor; and

a second switching configuration in which:

the first primary input terminal is coupled to the second primary input capacitor;
the second primary input terminal is coupled to the first primary input capacitor;
the first secondary input terminal is coupled to the first secondary input capacitor arrangement; and
the second secondary input terminal is coupled to the second secondary input capacitor arrangement.

# Figure 1

# Figure 2

EP 4 675 285 A1

Europäisches
Patentamt
European
Patent Office
Office européen
des brevets

# EUROPEAN SEARCH REPORT

Application Number

EP 24 30 6075

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/288491 A1 (HONDA KAZUTAKA [JP] ET AL) 14 September 2023 (2023-09-14) * paragraph [0039] - paragraph [0046]; figure 1 * | 1-14 | INV. G01R19/25 G01R31/3835 G01R35/00 |
| A | AU 724 902 B2 (ENCORE 2000 LTD) 5 October 2000 (2000-10-05) * page 4, line 12 - page 6, line 27; figures 2,5 * | 1-14 | |
| A | US 5 248 970 A (SOOCH NAVDEEP S [US] ET AL) 28 September 1993 (1993-09-28) * claims 1,3 * | 1-14 | |
| A | US 2019/148701 A1 (ASHRAFZADEH AHMAD [US]) 16 May 2019 (2019-05-16) * paragraph [0057] - paragraph [0064]; figures 8,10,11 * | 1-14 | |
| A | US 5 883 497 A (TURNBULL ROBERT R [US]) 16 March 1999 (1999-03-16) * figure 5A * | 1-14 | |
| A | JP 2005 261193 A (NISSAN MOTOR) 22 September 2005 (2005-09-22) * claim 1 * | 1-14 | TECHNICAL FIELDS SEARCHED (IPC) G01R H03M |
| A | US 2009/066338 A1 (YONEZAWA YOSHIAKI [JP]) 12 March 2009 (2009-03-12) * figure 1 * | 1-14 | |

The present search report has been drawn up for all claims

| Place of search | Date of completion of the search | Examiner |
|---|---|---|
| Munich | 22 November 2024 | Meliani, Chafik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

14

## ANNEX TO THE EUROPEAN SEARCH REPORT
## ON EUROPEAN PATENT APPLICATION NO.

EP 24 30 6075

This annex lists the patent family members relating to the patent documents cited in the above-mentioned European search report.
The members are as contained in the European Patent Office EDP file on
The European Patent Office is in no way liable for these particulars which are merely given for the purpose of information.

22-11-2024

| Patent document cited in search report | Publication date | Patent family member(s) | | Publication date |
|---|---|---|---|---|
| US 2023288491 A1 | 14-09-2023 | JP | 7396261 B2 | 12-12-2023 |
| | | JP | 2022096272 A | 29-06-2022 |
| | | US | 2023288491 A1 | 14-09-2023 |
| | | WO | 2022131296 A1 | 23-06-2022 |
| AU 724902 B2 | 05-10-2000 | AU | 724902 B2 | 05-10-2000 |
| | | EP | 1040546 A1 | 04-10-2000 |
| | | WO | 9927628 A1 | 03-06-1999 |
| US 5248970 A | 28-09-1993 | DE | 4237082 A1 | 19-05-1993 |
| | | GB | 2261336 A | 12-05-1993 |
| | | JP | H05259910 A | 08-10-1993 |
| | | US | 5248970 A | 28-09-1993 |
| | | US | 5818370 A | 06-10-1998 |
| US 2019148701 A1 | 16-05-2019 | CN | 111344582 A | 26-06-2020 |
| | | EP | 3710841 A1 | 23-09-2020 |
| | | US | 2019148701 A1 | 16-05-2019 |
| | | US | 2021151834 A1 | 20-05-2021 |
| | | US | 2024142538 A1 | 02-05-2024 |
| | | WO | 2019099213 A1 | 23-05-2019 |
| US 5883497 A | 16-03-1999 | US | 5541490 A | 30-07-1996 |
| | | US | 5561361 A | 01-10-1996 |
| | | US | 5629604 A | 13-05-1997 |
| | | US | 5838141 A | 17-11-1998 |
| | | US | 5847546 A | 08-12-1998 |
| | | US | 5883497 A | 16-03-1999 |
| JP 2005261193 A | 22-09-2005 | JP | 3804682 B2 | 02-08-2006 |
| | | JP | 2005261193 A | 22-09-2005 |
| US 2009066338 A1 | 12-03-2009 | JP | 4881819 B2 | 22-02-2012 |
| | | JP | 2009063511 A | 26-03-2009 |
| | | US | 2009066338 A1 | 12-03-2009 |

EPO FORM P0459

For more details about this annex : see Official Journal of the European Patent Office, No. 12/82